# EUROPÄISCHE PATENTSCHRIFT

(11) **EP 3 879 141 B1**
(45) Veröffentlichungstag und Bekanntmachung des Hinweises auf die Patenterteilung: **03.04.2024**
(21) Anmeldenummer: 21158899.1
(22) Anmeldetag: 24.02.2021
(51) Int. Cl.: F16J 15/06, F16J 15/12, H02K 5/124, H02K 11/01, F16L 23/12, F16L 23/18, F16L 23/20, F16L 23/22

(54) **DICHTUNGSANORDNUNG UND DEREN VERWENDUNG**
SEAL ASSEMBLY AND ITS USE
AGENCEMENT D'ÉTANCHÉITÉ ET SON UTILISATION

(30) Priorität: 10.03.2020 DE 102020106470
(43) Veröffentlichungstag der Anmeldung: 15.09.2021
(73) Patentinhaber: Carl Freudenberg KG, 69469 Weinheim (DE)
(72) Erfinder: DI MEO, Hervé Marcel Victor, 87310 Sant-Cyr (FR); NUSSKO, Marina, 68259 Mannheim (DE); HAUER, Matthias, 69469 Weinheim (DE); SCHROIFF, Volker, 69502 Hemsbach (DE); SUTTER, Marco, 69469 Weinheim (DE)

(56) Entgegenhaltungen:
- EP-A1- 3 312 480
- DE-A1-102016 221 611
- JP-A- 2001 284 872
- US-A- 2 796 457
- US-A- 5 702 111
- US-A1- 2006 220 324
- US-A1- 2008 042 437
- US-A1- 2009 295 103

## Beschreibung

### Technisches Gebiet

Die Erfindung betrifft eine Dichtungsanordnung und deren Verwendung, wobei die Dichtungsanordnung ein erstes und ein zweites Maschinenelement umfasst, die jeweils aus einem elektrisch leitfähigen Werkstoff bestehen und eine Dichtung, wobei die beiden Maschinenelemente durch die Dichtung gegeneinander abgedichtet sind, wobei die Dichtung einen elektrisch leitfähigen Tragkörper umfasst und wobei der Tragkörper zumindest einen im Wesentlichen dornförmigen Vorsprung aus einem elektrisch leitfähigen Werkstoff umfasst.

### Stand der Technik

Eine solche Dichtungsanordnung ist jeweils aus der US 2 796 457 und der US 5 702 111 bekannt. Aus der US 2 796 457 ist eine Dichtungsanordnung bekannt, gemäß der Präambel von Anspruch 1, wobei eine Dichtung mit einem elektrisch leitfähigen Tragkörper zwischen zwei metallischen Maschinenelementen angeordnet ist.

Für eine verbesserte Anpassung der Dichtung an die jeweiligen Gegebenheiten des Anwendungsfalls, insbesondere um das Abdichtungsergebnis zwischen den beiden metallischen Maschinenelementen zu verbessern, kann der elektrisch leitfähige Tragkörper sandwichartig zwischen zwei Lagen aus einem gummielastischen Dichtungswerkstoff angeordnet sein. Weil der gummielastische Dichtungswerkstoff elektrisch isolierend ist, wird dieser von den dornförmigen Vorsprüngen des Tragkörpers durchdrungen, derart, dass eine elektrisch leitende Verbindung zwischen den metallischen Maschinenelementen mittels des elektrisch leitfähigen Tragkörpers erreicht wird.

Eine weitere Dichtungsanordnung ist aus der US 5 702 111 bekannt. Die Dichtungsanordnung umfasst zwei elektrisch leitfähige Maschinenelemente, die durch eine Dichtung gegeneinander abgedichtet sind. Der elektrisch leitfähige Tragkörper der Dichtung ist von einem Dichtungswerkstoff umschlossen, wobei die dornförmigen Vorsprünge des Tragkörpers während der bestimmungsgemäßen Verwendung der Dichtungsanordnung den Dichtungswerkstoff durchdringen und dadurch eine elektrisch leitende Verbindung zwischen den beiden Maschinenelementen bewirken.

Die elektrisch leitfähige Verbindung ergibt sich während der Montage der Dichtungsanordnung. Durch eine Verpressung der Dichtung zwischen den Maschinenelementen durchstoßen die Vorsprünge den Dichtungswerkstoff und legen sich elektrisch leitend an das jeweils benachbarte Maschinenelement an.

Aus der DE 10 2010 018 270 A1 ist eine weitere elektrisch leitfähige Dichtungsanordnung bekannt, die in Hybrid- und Elektrofahrzeugen zur Anwendung gelangt. Die elektrisch leitfähige Dichtungsanordnung soll verhindern, dass verteilte RF-Energie zu unerwünschten Störungen führt, zum Beispiel zu Störungen in der Fahrzeugelektronik und/oder zu Beeinträchtigungen des Radioempfangs. Diese unerwünschten Störungen sollen dadurch verhindert werden, dass eine in der Dichtungsanordnung zur Anwendung gelangende Dichtung aus einem elektrisch leitfähigen Werkstoff besteht und elektrisch leitend zwischen einer abzudichtenden Welle und einem Gehäuse angeordnet ist.

Aus der US 2008/0042437 A1 ist eine Flanschanordnung bekannt, die im Zusammenhang mit einer Kraftstoffpumpe zur Anwendung gelangt.

Die Flanschanordnung umfasst ein erstes Maschinenelement, das schlauchförmig ausgebildet ist und aus einem elektrisch leitfähigen Kunststoff besteht sowie ein zweites Maschinenelement, das leitungsförmig ausgebildet ist und eine Flanschstruktur umfasst, wobei das zweite Maschinenelement aus einem elektrisch nicht-leitfähigen Kunststoff besteht.

Das zweite Maschinenelement ist mit seinem einen Ende, in Strömungsrichtung einerseits der Flanschstruktur, durch eine widerhakenförmige Verkrallung im ersten Maschinenelement befestigt.

Innenseitig im zweiten Maschinenelement ist eine Erdungshülse angeordnet, die das entsprechende stirnseitige Ende des zweiten Maschinenelements überdeckt und mit einem widerhakenförmig umlaufenden Vorsprung ebenfalls mit der Oberfläche des ersten Maschinenelements verkrallt ist.

Die Erdungshülse kann aus einem elektrisch leitfähigen Kunststoff bestehen.

Abgedichtet ist die Flanschanordnung im Bereich der Flanschstruktur des zweiten, elektrisch nicht-leitenden Maschinenelements gegenüber der Wand eines Treibstofftanks.

### Darstellung der Erfindung

Der Erfindung liegt die Aufgabe zugrunde, eine Dichtungsanordnung der eingangs genannten Art derart weiterzuentwickeln, dass diese als Leichtbau-Anordnung ausgebildet ist und ein niedriges Gewicht aufweist, insbesondere dass andere als metallische Werkstoffe für die Maschinenelemente zur Anwendung gelangen können und trotzdem elektromagnetische Störwellen abgeschirmt werden.

Dadurch soll die Dichtungsanordnung besonders vorteilhaft auf dem Gebiet der "e-mobility" eingesetzt werden können. Außerdem soll eine Verwendung einer solchen Dichtungsanordnung genannt werden.

Diese Aufgabe wird erfindungsgemäß durch eine Dichtungsanordnung gemäß Anspruch 1 und eine Verwendung gemäß Anspruch 6 gelöst. Auf vorteilhafte Ausgestaltungen der Dichtungsanordnung nehmen die auf Anspruch 1 direkt oder indirekt rückbezogenen Ansprüche Bezug.

Zur Lösung der Aufgabe ist es vorgesehen, dass zumindest eines der Maschinenelemente aus einem elektrisch leitfähigen Kunststoff besteht, der herstellungsbedingt von einer elektrisch isolierenden Spritzhaut zumindest teilweise überdeckt ist und dass der zumindest eine, im Wesentlichen dornförmige Vorsprung auf der der Spritzhaut zugewandten Seite des Tragkörpers angeordnet ist und die Spritzhaut vollständig durchdringt.

Üblicherweise bestehen die beiden elektrisch leitfähigen Maschinenelemente jeweils aus einem metallischen Werkstoff. Maschinenelemente aus metallischen Werkstoffen haben im Vergleich zu entsprechenden Maschinenelementen aus Kunststoff häufig ein deutlich höheres Gewicht. Insbesondere für mobile Verwendungen, also beispielsweise in Kraftfahrzeugen, wird Leichtbau zunehmend wichtiger, im Hinblick auf den Schutz der Umwelt durch die Reduzierung des Verbrauchs von Rohstoffen und Energie.

Gelangt die Dichtungsanordnung im Zusammenhang mit "e-mobility" zur Anwendung und die beiden Maschinenelemente sind Teil eines Gehäuses, in dem ein Elektrobauteil angeordnet ist, müssen der Innenraum des Gehäuses und die Umgebung gegeneinander elektromagnetisch abgeschirmt sein, um störende gegenseitige Einflüsse aus dem Innenraum des Gehäuses auf die Umgebung und von der Umgebung auf den Innenraum des Gehäuses möglichst auszuschließen. Für eine elektromagnetische Abschirmung kamen bisher jedoch ausschließlich Maschinenelemente aus metallischen Werkstoffen zur Anwendung, weil diese zuverlässig elektrisch leitfähig sind.

Kunststoffteile wurden bisher zur Abschirmung elektromagnetischer Störwellen nicht verwendet. Das ist vermutlich darauf zurückzuführen, dass Kunststoffe herstellungsbedingt eine Spritzhaut haben, die elektrisch isolierend ist. Die Spritzhaut ist auch dann elektrisch isolierend, wenn der Kunststoff, aus dem das Maschinenelement besteht, elektrisch leitfähig ist, zum Beispiel dadurch, dass elektrisch leitfähige Partikel im Kunststoff angeordnet sind.

Um einen elektrisch leitfähigen Kunststoff für zumindest eines der Maschinenelemente verwenden zu können, ist es jedoch erforderlich, dass die elektrisch isolierende Spritzhaut zur elektrischen Kontaktierung vollständig durchdrungen wird.

Erfindungsgemäß ist es dafür vorgesehen, dass die Dichtung einen elektrisch leitfähigen Tragkörper umfasst und dass der Tragkörper einen im Wesentlichen dornförmigen Vorsprung aus einem elektrisch leitfähigen Werkstoff umfasst, der auf der der Spritzhaut zugewandten Seite des Tragkörpers angeordnet ist und die Spritzhaut vollständig durchdringt.

Für eine gute elektromagnetische Abschirmung ist es notwendig, dass die beiden zur Anwendung gelangenden Maschinenelemente durch die Dichtung zuverlässig elektrisch leitend miteinander verbunden sind. Die elektrisch leitende Verbindung erfolgt durch den elektrisch leitfähigen Vorsprung des elektrisch leitfähigen Tragkörpers.

Unter einem im Wesentlichen dornförmigen Vorsprung wird im Rahmen der vorliegenden Erfindung im weitesten Sinne eine die elektrisch isolierende Spritzhaut durchdringende Geometrie verstanden, also zum Beispiel auch schneidende Formelemente, wie eine Schneidkante, die auf dem Tragkörper angeordnet ist.

Bevorzugt ist die Schneidkante umfangseitig umlaufend auf dem Tragkörper angeordnet. Dadurch wird eine besonders zuverlässige elektrisch leitende Verbindung zwischen den Maschinenelementen erreicht.

Dadurch, dass die Maschinenelemente durch die Dichtung elektrisch leitend miteinander verbunden sind, werden elektromagnetische Störwellen daran gehindert, aus dem Gehäuse in die Umgebung zu gelangen und die Funktion in der Umgebung angeordneter elektronischer Bauteile zu stören. Und/oder Störwellen aus der Umgebung werden daran gehindert, von der Umgebung in das Gehäuse zu gelangen und die Funktion im Inneren des Gehäuses angeordneter Elektrobauteile zu stören.

Gemäß einer vorteilhaften Ausgestaltung kann es vorgesehen sein, dass der Tragkörper und der Vorsprung einstückig ineinander übergehend und materialeinheitlich ausgebildet sind. Durch eine solche Ausgestaltung ist die Dichtung einfach und kostengünstig herstellbar. Außerdem ist von Vorteil, dass die Dichtungsanordnung insgesamt einen teilearmen Aufbau aufweist und dass dadurch die Gefahr von Fehlern bei der Montage der Dichtungsanordnung auf ein Minimum reduziert ist.

Der Tragkörper und der Vorsprung können aus einem metallischen Werkstoff bestehen. Tragkörper aus metallischen Werkstoffen sind auch in großen Stückzahlen einfach und kostengünstig herstellbar.

Die Dichtung kann als Flachdichtung ausgebildet sein. Solche Flachdichtungen gelangen üblicherweise zur Anwendung, um Flansche von Gehäuseteilen mehrteiliger Gehäuse gegeneinander abzudichten.

Wie zuvor bereits ausgeführt, kann das zumindest eine Maschinenelement durch ein Gehäuseteil eines Gehäuses gebildet sein.

Auch können beide Maschinenelemente als Gehäuseteile ausgebildet sein, das Gehäuse bilden und jeweils aus einem elektrisch leitfähigen Kunststoff bestehen. In einem solchen Fall würde der Tragkörper auf seinen einander abgewandten Seiten jeweils zumindest einen im Wesentlichen dornförmigen Vorsprung aufweisen, der die jeweilige Spritzhaut des jeweiligen Maschinenelements vollständig durchdringt, um die Maschinenelemente elektrisch leitend miteinander zu verbinden.

Besonders vorteilhaft ist die Verwendung der Dichtungsanordnung, wenn die beiden Maschinenelemente Gehäuseteile eines Gehäuses bilden und ein elektromagnetische Störwellen aussendendes Elektrobauteil elektromagnetisch abschirmend umschließen. Das Elektrobauteil kann zum Beispiel durch einen Elektromotor eines Kraftfahrzeugs gebildet sein. Durch die Dichtungsanordnung werden elektromagnetische Störwellen daran gehindert, aus dem Inneren des Gehäuses in die Umgebung zu gelangen und dort andere Elektrobauteile zu stören. Zum Beispiel Steuergeräte oder das Radio in einem Kraftfahrzeug.

### Kurzbeschreibung der Zeichnung

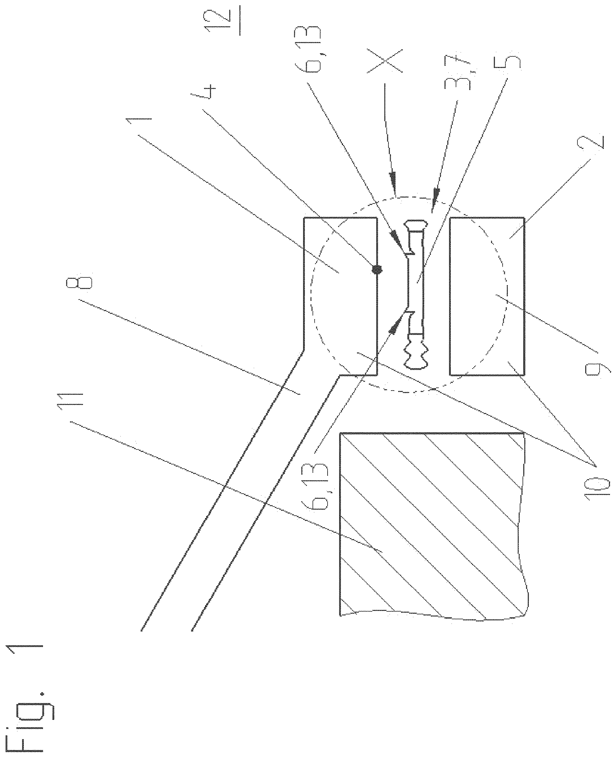

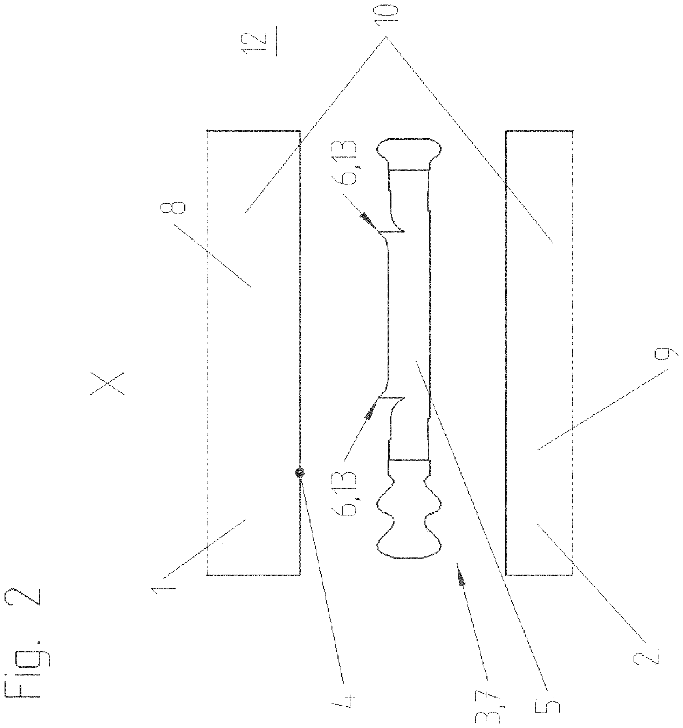

Ein Ausführungsbeispiel der erfindungsgemäßen Dichtungsanordnung wird nachfolgend anhand der Figuren 1 und 2 näher beschrieben.

Die Figuren 1 und 2 zeigen jeweils in schematischer Darstellung:
- Figur 1: einen Ausschnitt aus der Dichtungsanordnung, zum besseren Verständnis in Explosions-Darstellung,
- Figur 2: einen vergrößerten Ausschnitt X aus Figur 1.

### Ausführung der Erfindung

In Figur 1 ist ein Ausschnitt aus der erfindungsgemäßen Dichtungsanordnung in schematischer Darstellung gezeigt. Der Bereich X ist in Form einer Explosionsdarstellung gezeigt, um die Einzelteile aus der Dichtungsanordnung und deren Details besser erkennen zu können.

In Figur 1 ist die Dichtungsanordnung gezeigt, die das Gehäuse 10 für ein elektromagnetische Störwellen aussendendes Elektrobauteil 11, hier einen Elektromotor, umfasst. Die beiden Maschinenelemente 1, 2 bilden die beiden Gehäuseteile 8, 9 des Gehäuses 10.

Das erste 1 und das zweite Maschinenelement 2 bestehen jeweils aus einem elektrisch leitfähigen Werkstoff. Entweder bestehen beide Maschinenelemente 1 und 2 aus einem elektrisch leitfähigen Kunststoff oder nur eines der Maschinenelemente 1 oder 2.

Die beiden Maschinenelemente 1, 2 werden durch die Dichtung 3 gegeneinander abgedichtet und elektrisch leitend miteinander verbunden. Das Elektrobauteil 11 wird durch die beiden Maschinenelemente 1, 2 und die Dichtung 3 elektromagnetisch gegenüber der Umgebung 12 abgeschirmt.

Im gezeigten Ausführungsbeispiel besteht das erste Maschinenelement 1 aus einem elektrisch leitfähigen Kunststoff, das zweite Maschinenelement 2 demgegenüber aus einem metallischen Werkstoff. Das erste Maschinenelement 1 ist herstellungsbedingt von einer elektrisch isolierenden Spritzhaut 4 überdeckt. Diese elektrisch isolierende Spritzhaut 4 muss durchdrungen sein, um die beiden Maschinenelemente 1, 2 mittels der Dichtung 3 elektrisch leitend zu verbinden. Dadurch werden die elektromagnetischen Störwellen, die durch das Elektrobauteil 11 während seiner bestimmungsgemäßen Verwendung verursacht werden, gegenüber der Umgebung 12 elektromagnetisch abgeschirmt.

Dafür ist die Dichtung 3 speziell ausgebildet. Die Dichtung 3 umfasst einen elektrisch leitfähigen Tragkörper 5 aus einem metallischen Werkstoff, wobei der Tragkörper 5 im hier dargestellten Ausführungsbeispiel einen im Wesentlichen dornförmigen Vorsprung 6 in Form einer Schneidkante aufweist, die sich umfangsseitig umlaufend entlang des Tragkörpers 5 erstreckt. Der Tragkörper 5 und der dornförmige Vorsprung 6 bestehen im gezeigten Ausführungsbeispiel aus einem elektrisch leitfähigen Blech. Der dornförmige Vorsprung 6 durchdringt während der bestimmungsgemäßen Verwendung der Dichtungsanordnung die Spritzhaut 4 vollständig. Dadurch, dass der Vorsprung 6 die Spritzhaut 4 vollständig durchdringt, verbinden der Tragkörper 5 und der Vorsprung 6 das aus einem elektrisch leitenden Kunststoff bestehende erste Maschinenelement 1 mit dem aus einem metallischen Werkstoff bestehenden zweiten Maschinenelement 2 elektrisch leitend.

Der Tragkörper 5 und der Vorsprung 6 sind einstückig ineinander übergehend und materialeinheitlich ausgebildet.

Die Dichtung 3 ist im gezeigten Ausführungsbeispiel als Flachdichtung 7 ausgebildet. Die einander gegenüberliegenden Flansche der beiden Maschinenteile 1, 2 werden durch die Flachdichtung 7 gegeneinander abgedichtet.

In Figur 2 ist der Ausschnitt X aus Figur 1 in vergrößerter Darstellung gezeigt. Die Dichtung 3 umfasst, wie zuvor beschrieben, den elektrisch leitfähigen Tragkörper 5 und den in Richtung des ersten Maschinenelements 1 vorspringenden Vorsprung 6, der hier als umlaufende Schneidkante 13 ausgebildet ist. Durch die Schneidkante 13 wird die Spritzhaut 4, die herstellungsbedingt bei einem Kunststoffteil zwingend entsteht und elektrisch isolierend ist, vollständig durchdrungen.

## Patentansprüche

1. Dichtungsanordnung, umfassend ein erstes (1) und ein zweites Maschinenelement (2), die jeweils aus einem elektrisch leitfähigen Werkstoff bestehen und eine Dichtung (3), wobei die beiden Maschinenelemente (1, 2) durch die Dichtung (3) gegeneinander abgedichtet sind, wobei die Dichtung (3) einen elektrisch leitfähigen Tragkörper (5) umfasst und wobei der Tragkörper (5) zumindest einen im Wesentlichen dornförmigen Vorsprung (6) aus einem elektrisch leitfähigen Werkstoff umfasst, **dadurch gekennzeichnet, dass** zumindest eines der Maschinenelemente (1, 2) aus einem elektrisch leitfähigen Kunststoff besteht, der herstellungsbedingt von einer elektrisch isolierenden Spritzhaut (4) zumindest teilweise überdeckt ist und dass der zumindest eine, im Wesentlichen dornförmige Vorsprung (6) auf der der Spritzhaut (4) zugewandten Seite des Tragkörpers (5) angeordnet ist und die Spritzhaut (4) vollständig durchdringt.

2. Dichtungsanordnung nach Anspruch 1, **dadurch gekennzeichnet, dass** der Tragkörper (5) und der Vorsprung (6) einstückig ineinander übergehend und materialeinheitlich ausgebildet sind.

3. Dichtungsanordnung nach einem der Ansprüche 1 oder 2, **dadurch gekennzeichnet, dass** der Tragkörper (5) und der Vorsprung (6) aus einem metallischen Werkstoff bestehen.

4. Dichtungsanordnung nach einem der Ansprüche 1 bis 3, **dadurch gekennzeichnet, dass** die Dichtung (3) als Flachdichtung (7) ausgebildet ist.

5. Dichtungsanordnung nach Anspruch 1, **dadurch gekennzeichnet, dass** das zumindest eine Maschinenelement (1, 2) durch ein Gehäuseteil (8, 9) eines Gehäuses (10) gebildet ist.

6. Verwendung einer Dichtungsanordnung nach einem der Ansprüche 1 bis 5, **dadurch gekennzeichnet, dass** die beiden Maschinenelemente (1, 2) die Gehäuseteile (8, 9) des Gehäuses (10) bilden und ein elektromagnetische Störwellen aussendendes Elektrobauteil (11) elektromagnetisch abschirmend umschließen.

## Claims

1. Seal assembly comprising a first machine element (1) and a second machine element (2), which are in each case composed of an electrically conductive material, and a seal (3), wherein the two machine elements (1, 2) are sealed in relation to one another by the seal (3), wherein the seal (3) comprises an electrically conductive supporting body (5), and wherein the supporting body (5) comprises at least one substantially spike-shaped protrusion (6) of an electrically conductive material, **characterized in that** at least one of the machine elements (1, 2) is composed of an electrically conductive plastics material which for production reasons is at least partially covered by an electrically isolating injection-moulded surface (4), and **in that** the at least one substantially spike-shaped protrusion (6) is disposed on the side of the supporting body (5) that faces the injection-moulded surface (4) and completely penetrates the injection-moulded surface (4).

2. Seal assembly according to Claim 1, **characterized in that** the supporting body (5) and the protrusion (6) are configured to integrally transition into one another and in a materially integral manner.

3. Seal assembly according to one of Claims 1 or 2, **characterized in that** the supporting body (5) and the protrusion (6) are composed of a metallic material.

4. Seal assembly according to one of Claims 1 to 3, **characterized in that** the seal (3) is configured as a flat seal (7).

5. Seal assembly according to Claim 1, **characterized in that** the at least one machine element (1, 2) is formed by a housing part (8, 9) of a housing (10).

6. Use of a seal assembly according to one of Claims 1 to 5, **characterized in that** the two machine elements (1, 2) form the housing parts (8, 9) of the housing (10) and enclose in an electromagnetically shielding manner an electrical component (11) that emits electromagnetic interference waves.

## Revendications

1. Agencement d'étanchéité, comprenant un premier (1) et un deuxième élément de machine (2), qui sont chacun constitués d'un matériau électriquement conducteur, et un joint d'étanchéité (3), les deux éléments de machine (1, 2) étant rendus étanches l'un par rapport à l'autre par le joint d'étanchéité (3), le joint d'étanchéité (3) comprenant un corps porteur (5) électriquement conducteur et le corps porteur (5) comprenant au moins une saillie (6) essentiellement en forme de mandrin en un matériau électriquement conducteur, **caractérisé en ce qu'**au moins l'un des éléments de machine (1, 2) est constitué d'une matière plastique électriquement conductrice qui, en raison de la fabrication, est au moins partiellement recouverte d'une peau injectée (4) électriquement isolante et **en ce que** l'au moins une saillie (6) essentiellement en forme de mandrin est agencée sur le côté du corps porteur (5) tourné vers la peau injectée (4) et traverse complètement la peau injectée (4).

2. Agencement d'étanchéité selon la revendication 1, **caractérisé en ce que** le corps porteur (5) et la saillie (6) sont réalisés d'une seule pièce, en se fondant l'un dans l'autre et en un seul matériau.

3. Agencement d'étanchéité selon l'une quelconque des revendications 1 ou 2, **caractérisé en ce que** le corps porteur (5) et la saillie (6) sont constitués d'un matériau métallique.

4. Agencement d'étanchéité selon l'une quelconque des revendications 1 à 3, **caractérisé en ce que** le joint d'étanchéité (3) est réalisé sous forme de joint d'étanchéité plat (7).

5. Agencement d'étanchéité selon la revendication 1, **caractérisé en ce que** l'au moins un élément de machine (1, 2) est formé par une partie de boîtier (8, 9) d'un boîtier (10).

6. Utilisation d'un agencement d'étanchéité selon l'une quelconque des revendications 1 à 5, **caractérisée en ce que** les deux éléments de machine (1, 2) forment les parties de boîtier (8, 9) du boîtier (10) et entourent un composant électrique (11) émettant des ondes électromagnétiques parasites en le protégeant électromagnétiquement.
